# EUROPEAN PATENT SPECIFICATION

(11) **EP 3 023 513 B1**
(45) Date of publication and mention of the grant of the patent: **03.06.2020**
(21) Application number: 14193687.2
(22) Date of filing: 18.11.2014
(51) Int. Cl.: C23C 14/28, C23C 14/08, C23C 14/00

(54) **Method to produce nanoporous coatings in open air conditions**
Verfahren zur Herstellung von nanoporösen Beschichtungen an freier Luft
Procédé pour produire des revêtements nanoporeux dans des conditions d'air ouvert

(43) Date of publication of application: 25.05.2016
(73) Proprietor: Universidad de Vigo, 36310 Vigo (Pontevedra) (ES)
(72) Inventor: Boutinguiza Larosi, Mohamed, 36310 Vigo-Pontevedra (ES); del Val García, Jesús, 36310 Vigo-Pontevedra (ES); Comesaña Piñeiro, Rafael, 36310 Vigo-Pontevedra (ES); Riveiro Rodríguez, Antonio, 36310 Vigo-Pontevedra (ES); Lusquiños Rodríguez, Fernando, 36310 Vigo-Pontevedra (ES); Pou Saracho, Juan María, 36310 Vigo-Pontevedra (ES)
(74) Representative: ABG Intellectual Property Law, S.L.

(56) References cited:
- US-A1- 2004 140 296
- US-A1- 2012 128 963
- KANG YONG SONG ET AL: "Preparation of Transparent Particulate MoO 3 /TiO 2 and WO 3 /TiO 2 Films and Their Photocatalytic Properties", CHEMISTRY OF MATERIALS, vol. 13, no. 7, 23 June 2001 (2001-06-23), pages 2349-2355, XP055087200, US ISSN: 0897-4756, DOI: 10.1021/cm000858n
- JIN-WOOK LEE ET AL: "Rutile TiO2-based perovskite solar cells", JOURNAL OF MATERIALS CHEMISTRY A: MATERIALS FOR ENERGY AND SUSTAINABILITY, vol. 2, no. 24, 1 January 2014 (2014-01-01), pages 9251-9259, XP055416270, GB ISSN: 2050-7488
- NEDYALKOV N ET AL: "Nanostructured Au film produced by pulsed laser deposition in air at atmospheric pressure", OPTICS AND LASER TECHNOLOGY, vol. 64, 22 May 2014 (2014-05-22), pages 41-45, XP029038293, ISSN: 0030-3992, DOI: 10.1016/J.OPTLASTEC.2014.03.022

## Description

### FIELD OF THE INVENTION

This invention is related to a method for producing nanoporous coatings on substrates by means of laser radiation application. The method may be advantageously applied for the preparation of thin films of coatings with a high degree of porosity at a nanoscale range, that is, ultra-high nanoporous coatings.

### BACKGROUND

Coatings have been used for decades as a perfect way to modify the properties of the surface of a material without altering the intrinsic properties of the bulk. Specially, thin layers allow keeping the dimensions of the coated pieces without losing their tolerances. Typical techniques available to produce thin films such as sputtering (RF, ion beam, or magnetron), chemical vapour deposition, pulsed laser deposition, molecular beam epitaxy, plasma-assisted chemical vapour deposition, cathodic arc deposition, laser chemical vapour deposition, produce dense or low porosity coatings. The production of the films by these techniques is carried out inside of a reaction chamber in which, normally, high or ultra-high vacuum conditions are obtained prior to the deposition process itself (see as example the book "M. Ohring (2001). Materials Science of Thin Films (2nd ed.). Boston: Academic Press*").*

Highly porous thin films make the surface of a material a very reactive one. This is important to activate very passive materials in order to use them as sensors or to promote biointegration to living tissues when used to replace damaged tissues in human bodies.

If these thin films have a nanostructured surface, the reactivity increases exponentially. This is due to the fact that the number of atoms on the surface of this material is huge compared to that of a bulk material. Therefore, the coordination number for these atoms (i.e.: the neighbour atoms) is lower than in the case of a bulk material and more dangling bonds are present, leading to an increase of surface reactivity.

There is a need of a technique that allows producing thin films of highly porous coatings at a nanoscale range, without the need of sophisticated and expensive reaction chambers and vacuum equipment. Relevant prior art is disclosed in the following documents:
US 2004/140296 A1
KANGYONG SONG ET AL: "Preparation of Transparent Particulate MoO 3 /TiO 2 and WO 3 / TiO 2 Films and Their Photocatalytic Properties",CHEMISTRY OF MATERIALS, vol. 13, no. 7, 23 June 2001 (2001-06-23), pages 2349-2355, XP055087200,US ISSN: 0897-4756
US 2012/128963 A1
JIN-WOOK LEE ET AL: "RutileTiO2-based perovskite solar cells",JOURNAL OF MATERIALS CHEMISTRY A: MATERIALS FOR ENERGY AND SUSTAINABILITY, vol. 2, no. 24, 1 January 2014 (2014-01-01), pages 9251-9259, XP055416270,GB ISSN: 2050-7488
NEDYALKOV N ET AL: "Nanostructured Au film produced by pulsed laser deposition in air at atmospheric pressure",OPTICS AND LASER TECHNOLOGY, vol. 64, 22 May 2014 (2014-05-22), pages 41-45, XP029038293,ISSN: 0030-3992

### BRIEF DESCRIPTION OF THE INVENTION

The invention here described is a solution for the above problem since provides a method to obtain nanoporous coatings, and in particular ultra-high nanoporous coatings, under open air conditions, without the need of vacuum preconditioning of the atmosphere nor a dedicated reaction chamber. The coatings obtained according to the present invention contain a myriad of nanoporous and nanoparticles that increase the surface reactivity of a given substrate.

The inventors of the present invention have developed a one-step method for the production of nanoporous metallic and/or metal oxide coatings on substrates under ambient conditions by means of laser radiation application, said method comprising:
- providing a metallic target (3) and a substrate (4) near each other;
- focussing a laser beam (1) on the metallic target surface while supplying an assist gas to the interaction zone of the laser beam and the target surface so as to generate a plasma plume that leads to the formation of metallic and/or metal oxide species, so that said species are ejected from said target surface towards the same side of the target surface on which the laser beam incides, and deposited on the substrate; and wherein ambient conditions mean that the process is not carried out under vacuum or controlled atmosphere in a reaction chamber.

The coatings so produced may be ultra-high nanoporous, i.e. thin films of coatings with a high degree of porosity at a nanoscale range. The degree of porosity typically ranges from about 40 vol. % to about 70 vol. %. In a particular embodiment, the coatings produced by the method of the invention have a myriad of nanopores ranging from about 5 nm to about 50 nm in diameter. In another particular embodiment, the coatings produced have a film-thickness in a micrometre range (from about 0.1 micrometres to about 10 micrometres). According to a more particular embodiment, films of about 1.25 micrometres thickness are obtained.

The method of the invention may be carried out with both continuous wave and pulsed lasers.

Changing the composition of the target allows producing coatings with different composition. Using combined targets (i.e.: targets made out of two or more materials) lead to the production of coatings with combined composition (i.e.: layered composition).

According to the invention as claimed in the appended claims assist gases (2) are used in the interaction zone of the laser beam and the metallic target in order to enhance oxidation or reduction, to obtain doped coatings.

Further, in order to improve the adhesion of the coatings, heating means (5) such as a heater may be mounted under the substrate (4) to increase the temperature of the substrate.

The present invention is also directed to a nanoporous metallic and/or metal oxide coating obtainable by the method described herein, characterized in that it has a degree of porosity ranging from 40 to 70 vol. % when measured by high-resolution transmission electron microscopy, the nanopores in the coating have a diameter ranging from 5 to 50 nm when measured by high-resolution transmission electron microscopy, and the coating has a thickness ranging from 0.1 to 10 micrometres when measured by scanning electron microscopy, and wherein the substrate is selected from the group consisting of glass, steel, silicon, silicon dioxide, silicon nitride, copper and aluminum. In a preferred embodiment, the method is carried out to produce a TiO₂ coating.

These aspects and preferred embodiments thereof are additionally also defined hereinafter in the detailed description, as well as in the claims.

### BRIEF DESCRIPTION OF THE FIGURES

**Figure 1** illustrates the experimental setup according to one embodiment of the invention: 1. Laser beam, 2. Auxiliary gas flow, 3. Target, 4. Substrate, 5. Heating means.
**Figure 2** illustrates the SEM of the surface of TiO₂ coating obtained by a 300 W continuous wave laser in air according to one embodiment of the present invention, as described in example 1.
**Figure 3** shows a cross section of a micrometric TiO₂ coating on glass substrate obtained by the use of a 300 W continuous wave laser in air according to one embodiment of the present invention, as described in example 1.
**Figure 4** shows the HRTEM of a selected part of a film of TiO₂ nanoparticles obtained by a 300 W continuous wave laser in air according to one embodiment of the present invention, as described in example 1.
**Figure 5** exhibits the grazing incidence X-Ray diffraction (GIXRD) patterns of a micrometric TiO₂ coating on glass substrate obtained by the use of a 300 W continuous wave laser in air according to one embodiment of the present invention, as described in example 1. The pattern reveals the presence of Rutile and Anatase phases in the coating.

### DETAILED DESCRIPTION OF THE INVENTION

An object of the invention is to deposit nanoporous coatings, specially ultra-high nanoporous coatings, in open air on a substrate. The substrate is located at close distance to the target so as to avoid the need of vacuum or controlled atmosphere, enabling the formation of thin film coatings with good adherence under ambient conditions. Such coatings may be intended for very different applications, e.g. coating of TiO₂ for photocatalysis, or coating of doped TiO₂ on conductive glass for solar cells, etc.

As used herein, the terms "ambient conditions" or "open air conditions" mean that the process is not carried out under vacuum or controlled atmosphere, but in open air. The use of assist gases and/or heating elements is however contemplated.

As used herein, the term "about" means a slight variation of the value specified, preferably within 10 percent of the value specified. Nevertheless, the term "about" can mean a higher tolerance of variation depending on for instance the experimental technique used. Said variations of a specified value are understood by the skilled person and are within the context of the present invention. Further, to provide a more concise description, some of the quantitative expressions given herein are not qualified with the term "about". It is understood that, whether the term "about" is used explicitly or not, every quantity given herein is meant to refer to the actual given value, and it is also meant to refer to the approximation to such given value that would reasonably be inferred based on the ordinary skill in the art, including equivalents and approximations due to the experimental and/or measurement conditions for such given value.

In the present invention, pore diameters are expressed in terms of the values obtained by High-resolution transmission electron microscopy (HRTEM). In the present invention, film-thicknesses are expressed in terms of the value obtained by scanning electron microscopy (SEM). In the present invention, degrees of porosity are expressed in terms of the value obtained by HRTEM.

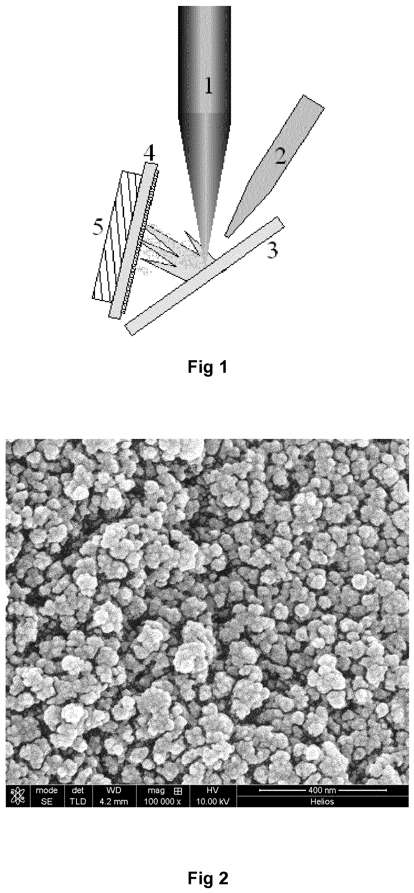

The method for the production of nanoporous and ultra-high nanoporous metallic and metal oxide coatings under ambient conditions of the present invention is carried out in a suitable system, an example of which is shown in Figure 1. This method basically consists of the following: the target material (3) is located on a suitable support. The laser beam (1) is normally led towards the target material (3) by means of a suitable beam guiding system (which can be either a reflective or refractive system, i.e.: mirror based, lens, based, or optical fiber based, according to the type of laser source used). An auxiliary gas flow (2) is supplied to the interaction area between the laser beam (1) and the target material (3). Due to the temperature and pressure developed by the expansion of plasma plumes, the ablated species are adhered on the substrate (4). Also heating elements such as a heater (5) may be incorporated under the substrate (4) to increase the temperature of the substrate in order to enhance the energy of the species reaching the substrate, therefore increasing coating adhesion.

During the method of the invention, different experimental parameters can be changed, leading to modification of film properties. First, the laser parameters such as laser fluence, wavelength, pulse duration and repetition rate can be altered. Second, the preparation conditions, including target-to-substrate distance, substrate temperature and assist/auxiliary gases, may be varied, which all influence the film growth.

Metallic targets useful in the present invention include, but are not limited to, titanium, yttrium, tantalum, molybdenum, tungsten, iron, steel, cobalt, palladium, platinum, copper, silver, gold, zinc, cadmium, aluminum, and silicon.

The size and the shape of the metallic target can vary greatly. According to particular embodiments, the metallic target used is selected from a plate, a disc or a wire. Plate dimensions suitable for the method of the invention are for instance: 12 mm x 25 mm x 0.13 mm, 50 mm x 50 mm x 0.13 mm, or 25 mm x 50 mm x 0.13 mm. When a metallic wire is used as target, its diameter typically ranges from about 0.5 mm to about 0.6 mm.

As described previously, the method of the invention may be carried out with both continuous wave and pulsed lasers. A variety of laser systems may be used in the method of the invention, provided that the wavelength is appropriate for producing the ablation of species from the target, that is, the target material must absorb enough energy at the wavelength of the laser beam so as to generate a plasma plume able to carry out the generated species. According to a particular embodiment, the laser radiation can come from a laser equipment selected from a CO₂, CO, N₂, Nd:YAG, Er:YAG, Nd:glass, Nd:YVO4, Ruby, HeNe, HeCd, HeHg, Cu, I, Ar, Kr laser, a laser diode, a fiber laser, a disc laser, a chemical laser, an excimer laser, an alexandrite laser, an emerald laser or a dye laser. According to another embodiment, the laser is selected from CO₂, Nd:YAG, Er:YAG, Nd:YVO4, diode, fiber laser, disc laser or excimer laser.

The system may also include optical elements for delivering the laser beam such that the beam is focused onto the target surface with an appropriate average energy density and an appropriate energy density distribution. Different beam guiding systems are known for the skilled person.

For the reactive metallic targets, such as Ti, oxide coatings can be obtained (TiO₂), while for non-reactive metallic targets, such as Ag, pure metallic coatings are obtained. In order to enhance oxidation or reduction, oxidative (e.g. oxygen, carbon dioxide) or reductive gases (e.g. carbon monoxide) can be used in the interaction zone. Assist gases can be used also to obtain doped coatings, e.g N-doped or C-doped TiO₂ coatings. Example of assist/auxiliary gases are for instance O₂ and CO₂ (as oxidative gases), CO (as reductive gas), and NH₃, CH₄, and C₂H₂ (as doping gases).

The process of the invention can be used to prepare nanoporous and ultra-high nanoporous coatings of many different metal elements including, without limitation, titanium, silicon, cobalt, zinc, steel, aluminum, copper, gold, silver, or platinum as well as to prepare ultra-high nanoporous coatings of compound materials such as oxides, nitrides and carbides (e.g. TiO₂, CeO₂, TiC, CoO, ZnSe, CdS). According to a preferred embodiment, this invention is related to producing ultra-high nanoporous coatings of crystalline TiO₂.

Substrates useful in the method of the present invention include, but are not limited to, glass, steel, silicon, silicon dioxide, silicon nitride, copper and aluminum. A variety of techniques, including interferometry, optical spectroscopy and Laser-Induced Fluorescence (LIF), can be used to investigate the plasma creation and expansion.

Optimum deposition conditions can be also investigated through a change in the target-substrate distance. Good results have been obtained when the distance between the target and the substrate is from about 5 mm to about 15 mm. Of course, values outside this range are also contemplated in the present invention. In general, the metallic target and the substrate (4) are placed at a distance from each other from about 2 mm to about 20 mm. The target-substrate distance is measured from the substrate's central point to the target's central point.

According to particular embodiments, the laser beam is focused onto the surface of the target at an angle of incidence from about 20 ° to about 50 °, more particularly from about 30 ° to about 40 °. In a specific embodiment, the angle of incidence of the laser beam onto the surface of the target is about 35 °. As expressed herein, the angle of incidence is the angle between the incident laser beam and the surface of the target.

The substrate and the target may be disposed in a parallel, perpendicular or inclined arrangement. Preferably, the substrate and the target are inclined from each other. According to particular embodiments, the substrate is inclined at an angle from about 30 ° to about 80 ° to the target, more particularly from about 40 ° to about 75 °.

In order to produce tunable morphology and thickness coatings the substrate is held in the vicinity of plasma plume and is normally rotated by a driving unit. A heating element such as a heater can be incorporated under the substrate to increase the temperature on the substrate, in order to control the crystallinity and the adherence. According to one embodiment, the heating element provides a temperature ranging from about 100 to about 500 °C. According to other embodiment, no heating element is present and the coating is deposited at room temperature.

Some particular embodiments of the invention are described below:
According to a particular embodiment, the process was performed using a pulsed Nd:YAG laser (Rofin-Sinar RSY-500) emitting at the fundamental wavelength of λ = 1064 nm and maximum power of 500 W. The laser radiation was guided by means of a 600 µm core diameter optical fiber and coupled to the working station via expanding and collimating optics, which provides 1-3 ms pulse duration at a repetition rate of 50Hz and 0.8-8.4 J pulse energy.

According to another particular embodiment, a diode end-pumped Nd:YVO₄ (Rofin-SinarPowerLine E) emitting a TEM⁰⁰ pulsed laser beam (M²<1.2) at 1064, 532 and 355 nm wavelengths. The pulse duration was 10 ns at 20 kHz of frequency. The laser beam was focused using lenses with different focal length (211, 365, and 235 mm). Laser beam was focused onto the surface of target at an angle of incidence 35°. The coating was deposited on glass substrate placed 5 to 15 mm away and inclined at an angle of 40 to 75 ° to the target.

According to another particular embodiment, the process was performed using a RofinSinar SCx10 slab laser delivering a maximum average power of 100 W and emitting at 10.6 µm. The pulse duration was 10 ns at 16 kHz of frequency. Laser beam was focused onto the surface of target at an angle of incidence 35°. The coating was deposited on glass substrate placed 5 to 15 mm away and inclined at an angle of 40 to 75° to the target.

The invention will now be further described by way of reference to the following examples which are provided for the purpose of illustration only and should not be construed as being limiting on the invention.

### Examples

The following descriptions are practical examples of the application of the method of the invention.

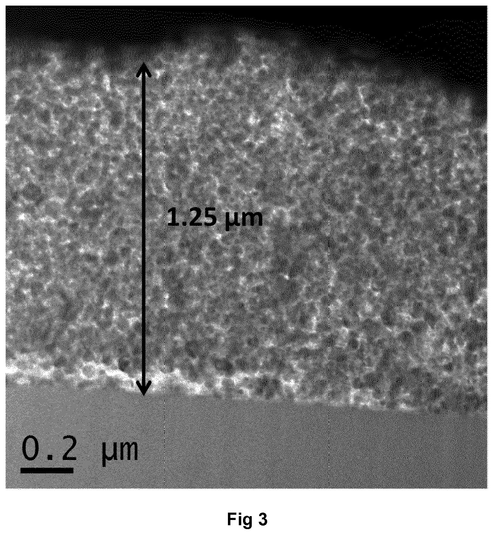

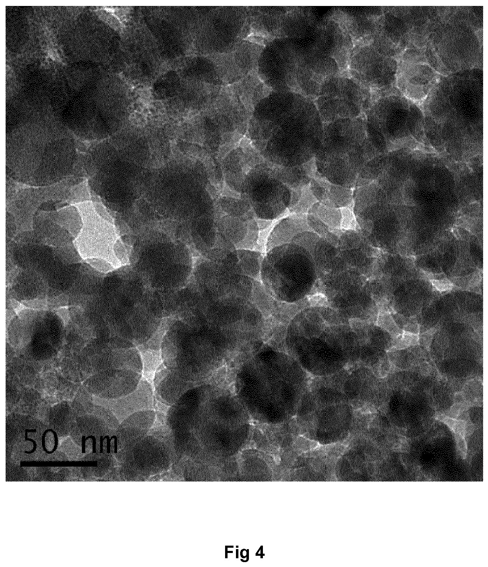

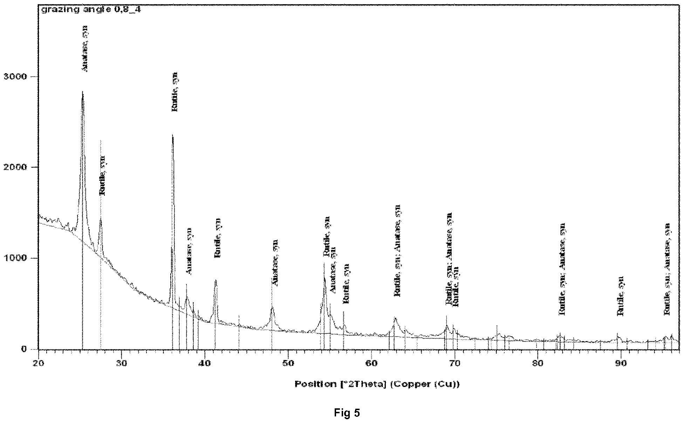

Plates and foils of Ag, Pd and Ti with 99.99% of purity were cleaned and sonicated to be ablated by laser in air using different system lasers:
1.- One of the laser sources used was a pulsed Nd:YAG laser with a wavelength of 1064 nm and delivering a maximum average power of 500 W. The laser beam was coupled to an optical fiber of 600 µm core diameter and focused onto the upper surface of the target by means of 125 mm of focal length lens, where the spot diameter at normal incidence for a pulsed laser was about 0.20 mm. Other parameters were varied as follows: laser pulse width 1-2 ms, frequency = 10 Hz, and pulse energy 2-8 J.
   The TiO₂ coating shown in figures 2 to 4 has been obtained using this laser source operating at 300 W and under the mentioned experimental conditions. Figure 5 also relates to the same TiO₂ coating.
2.- Other laser was a CW monomode Ytterbium doped fiber laser (YDFL), with a maximum average power of 200 W and wavelength of 1075 nm. The delivered irradiance ranged between 2×10⁵ and 10⁶ W/cm². The laser beam was coupled to an optical fiber of 50 µm core diameter and focused on the upper surface of the target by means of 125 mm of focal length lens. The laser beam was kept in relative movement with respect to the metallic plate at a scanning speeds ranging from of 5 to 15 mm/s.
   Coatings made out of pure Ag have been obtained with this system.
3.- Other laser source used consisted of ns diode-pumped Nd:YVO₄ laser system for micro-machining applications, providing laser pulses at 532 nm with pulse duration of 50 ns, a repetition rate of 20 kHz and an average output power of 6 W. A jet of an auxiliary inert gas (Ar) was used to prevent the synthesized nanoparticles from oxidation on one hand and to direct the particles to the substrate on the other hand. The laser beam was kept in relative movement with respect to the metallic plate at a scanning speed of 100 mm/s.

Under these experimental conditions coatings of Pd nanoparticles have been obtained on glass substrates.

## Claims

1. A method for producing a nanoporous metallic and/or metal oxide coating on a substrate under ambient conditions, said method comprising:
- providing a metallic target (3) and a substrate (4) near each other;
- focussing a laser beam (1) on the metallic target surface while supplying an assist gas to the interaction zone of the laser beam and the target surface so as to generate a plasma plume that leads to the formation of metallic and/or metal oxide species, so that said species are ejected from said target surface towards the same side of the target surface on which the laser beam incides, and deposited on the substrate;
and wherein ambient conditions mean that the process is not carried out under vacuum or controlled atmosphere in a reaction chamber.

2. The method according to claim 1 wherein the metallic target is selected from the group consisting of titanium, yttrium, tantalum, molybdenum, tungsten, iron, steel, cobalt, palladium, platinum, copper, silver, gold, zinc, cadmium, aluminum, and silicon.

3. The method according to claims 1 or 2, wherein the metallic target is selected from a plate, a disc or a wire.

4. The method according to any one of claims 1 to 3, wherein the substrate and the target is disposed in perpendicular or inclined arrangement.

5. The method according to any one of claims 1 to 4, wherein the laser beam is focused onto the surface of the target at angle of incidence from about 20° to about 50°.

6. The method according to any one of the preceding claims, wherein the laser is selected from the group consisting of a CO₂, CO, N₂, Nd:YAG, Er:YAG, Nd:glass, Nd:YVO4, Ruby, HeNe, HeCd, HeHg, Cu, I, Ar, Kr laser, a laser diode, a fiber laser, a disc laser, a chemical laser, an excimer laser, an alexandrite laser, an emerald laser or a dye laser.

7. The method according to any one of the preceding claims wherein the coating produced has a thickness ranging from 0.1 to 10 micrometres when measured by scanning electron microscopy.

8. The method according to any one of the preceding claims, wherein the assist gas is selected from the group consisting of O₂, CO₂, CO, NH₃, CH₄, and C₂H₂.

9. The method according to any one of the preceding claims, further comprising the use of a heater near to the substrate.

10. The method according to any one of the preceding claims, wherein the substrate is selected from the group consisting of glass, steel, silicon, silicon dioxide, silicon nitride, copper and aluminum.

11. A substrate coated by a nanoporous metallic and/or metal oxide coating, wherein said coating is obtainable by the method as defined in any one of the preceding claims, **characterized in that** it has a degree of porosity ranging from 40 to 70 vol. % when measured by high-resolution transmission electron microscopy, the nanopores in the coating have a diameter ranging from 5 to 50 nm when measured by high-resolution transmission electron microscopy, and the coating has a thickness ranging from 0.1 to 10 micrometres when measured by scanning electron microscopy, and wherein the substrate is selected from the group consisting of glass, steel, silicon, silicon dioxide, silicon nitride, copper and aluminum.

12. The substrate coated according to claim 11, wherein the coating is a TiO₂ coating.

## Patentansprüche

1. Verfahren zur Herstellung einer nanoporösen Metall- und/oder Metalloxidbeschichtung auf einem Substrat unter Umgebungsbedingungen, wobei man
- ein metallisches Target (3) und ein Substrat (4) nahe beieinander bereitstellt;
- einen Laserstrahl (1) auf die Oberfläche des metallischen Targets fokussiert, während man ein Hilfsgas zur Wechselwirkungszone des Laserstrahls und der Targetoberfläche leitet, um eine Plasmawolke zu erzeugen, die zur Bildung von Metall- und/oder Metalloxidspezies führt, so dass die Spezies zur gleichen Seite der Targetoberfläche, von welcher der Laserstrahl einfällt, aus der Targetoberfläche ausgestoßen werden und auf dem Substrat abgeschieden werden;
und wobei unter Umgebungsbedingungen verstanden wird, dass das Verfahren nicht unter Vakuum oder einer kontrollierten Atmosphäre in einer Reaktionskammer durchgeführt wird.

2. Verfahren nach Anspruch 1, wobei das metallische Target unter Titan, Yttrium, Tantal, Molybdän, Wolfram, Eisen, Stahl, Cobalt, Palladium, Platin, Kupfer, Silber, Gold, Zink, Cadmium, Aluminium und Silizium ausgewählt ist.

3. Verfahren nach Anspruch 1 oder 2, wobei das metallische Target unter einer Platte, einer Scheibe oder einem Draht ausgewählt ist.

4. Verfahren nach einem der Ansprüche 1 bis 3, wobei das Substrat und das Target in einer rechtwinkligen oder geneigten Anordnung anordnet sind.

5. Verfahren nach einem der Ansprüche 1 bis 4, wobei man den Laserstrahl auf der Oberfläche des Targets in einem Einfallswinkel von etwa 20° bis etwa 50° fokussiert.

6. Verfahren nach einem der vorhergehenden Ansprüche, wobei der Laser unter einem CO₂-, CO-, N₂-, Nd:YAG-, Er:YAG-, Nd:Glas-, Nd:YVO4-, Rubin-, HeNe-, HeCd-, HeHg-, Cu-, I-, Ar-, Kr-Laser, einer Laserdiode, einem Faserlaser, einem Scheibenlaser, einem chemischen Laser, einem Exzimerlaser, einem Alexandrit-Laser, einem Emerald-Laser oder einem Farbstofflaser ausgewählt ist.

7. Verfahren nach einem der vorhergehenden Ansprüche, wobei die hergestellte Beschichtung bei Messung durch Rasterelektronenmikroskopie eine Dicke im Bereich von 0,1 bis 10 Mikrometer aufweist.

8. Verfahren nach einem der vorhergehenden Ansprüche, wobei das Hilfsgas unter O₂, CO₂, CO, NH₃, CH₄ und C₂H₂ ausgewählt ist.

9. Verfahren nach einem der vorhergehenden Ansprüche, wobei man außerdem ein Heizelement in der Nähe des Substrats verwendet.

10. Verfahren nach einem der vorhergehenden Ansprüche, wobei das Substrat unter Glas, Stahl, Silizium, Siliziumdioxid, Siliziumnitrid, Kupfer und Aluminium ausgewählt ist.

11. Mit einer nanoporösen Metall- und/oder Metalloxidbeschichtung beschichtetes Substrat, wobei die Beschichtung nach einem Verfahren gemäß Definition in einem der vorhergehenden Ansprüche erhältlich ist, **dadurch gekennzeichnet, dass** sie bei Messung durch hochauflösende Transmissionselektronenmikroskopie einen Porositätsgrad im Bereich von 40 bis 70 Vol.% aufweist, die Nanoporen in der Beschichtung bei Messung durch hochauflösende Transmissionselektronenmikroskopie einen Durchmesser im Bereich von 5 bis 50 nm aufweisen, und die Beschichtung bei Messung durch Rasterelektronenmikroskopie eine Dicke im Bereich von 0,1 bis 10 Mikrometer aufweist, und das Substrat unter Glas, Stahl, Silizium, Siliziumdioxid, Siliziumnitrid, Kupfer und Aluminium ausgewählt ist

12. Beschichtetes Substrat nach Anspruch 11, wobei die Beschichtung eine TiO₂-Beschichtung ist.

## Revendications

1. Un procédé de production d'un revêtement métallique et/ou d'oxyde métallique nanoporeux sur un substrat dans des conditions ambiantes, ledit procédé comprenant :
- le fait de prévoir une cible métallique (3) et un substrat (4) à proximité l'un de l'autre ;
- le fait de focaliser un faisceau laser (1) sur la surface de la cible métallique tout en fournissant un gaz d'assistance à la zone d'interaction du faisceau laser et de la surface de la cible de manière à générer un nuage de plasma qui conduit à la formation d'espèces métalliques et/ou d'oxydes métalliques, de sorte que lesdites espèces soient éjectées de ladite surface de la cible vers le même côté de la surface de la cible sur lequel le faisceau laser est incident, et soient déposées sur le substrat ;
lesdites conditions ambiantes signifiant que le procédé n'est pas mis en œuvre sous vide ou sous une atmosphère contrôlée dans une chambre de réaction.

2. Le procédé selon la revendication 1, dans lequel la cible métallique est choisie dans le groupe constitué par le titane, l'yttrium, le tantale, le molybdène, le tungstène, le fer, l'acier, le cobalt, le palladium, le platine, le cuivre, l'argent, l'or, le zinc, le cadmium, l'aluminium et le silicium.

3. Le procédé selon les revendications 1 ou 2, dans lequel la cible métallique est choisie parmi une plaque, un disque ou un fil.

4. Le procédé selon l'une quelconque des revendications 1 à 3, dans lequel le substrat et la cible sont disposés selon une disposition perpendiculaire ou inclinée.

5. Le procédé selon l'une quelconque des revendications 1 à 4, dans lequel le faisceau laser est focalisé sur la surface de la cible selon un angle d'incidence d'environ 20° à environ 50°.

6. Le procédé selon l'une quelconque des revendications précédentes, dans lequel le laser est choisi dans le groupe constitué par un laser à CO₂, CO, N₂, Nd:YAG, Er:YAG, Nd:verre, Nd:YVO4, Ruby, HeNe, HeCd, HeHg, Cu, I, Ar, Kr, une diode laser, un laser à fibre, un laser à disque, un laser chimique, un laser à excimère, un laser à alexandrite, un laser à émeraude ou un laser à colorant.

7. Le procédé selon l'une quelconque des revendications précédentes, dans lequel le revêtement produit a une épaisseur comprise entre 0,1 et 10 micromètres lorsqu'elle est mesurée par microscopie électronique à balayage.

8. Le procédé selon l'une quelconque des revendications précédentes, dans lequel le gaz d'assistance est choisi dans le groupe constitué par O₂, CO₂, CO, NH₃, CH₄ et C₂H₂.

9. Le procédé selon l'une quelconque des revendications précédentes, comprenant en outre l'utilisation d'un élément chauffant à proximité du substrat.

10. Le procédé selon l'une quelconque des revendications précédentes, dans laquelle le substrat est choisi dans le groupe constitué par le verre, l'acier, le silicium, le dioxyde de silicium, le nitrure de silicium, le cuivre et l'aluminium.

11. Un substrat revêtu d'un revêtement métallique et/ou d'oxyde métallique nanoporeux, ledit revêtement étant apte à être obtenu par le procédé tel que défini dans l'une quelconque des revendications précédentes, **caractérisé en ce qu'**il a un degré de porosité allant de 40 à 70 % en volume lorsqu'il est mesuré par microscopie électronique à transmission de haute résolution, les nanopores dans le revêtement ayant un diamètre allant de 5 à 50 nm lorsqu'il est mesuré par microscopie électronique à transmission de haute résolution, et le revêtement a une épaisseur allant de 0,1 à 10 micromètres lorsqu'il est mesuré par microscopie électronique à balayage, et le substrat étant choisi dans le groupe constitué par le verre, l'acier, le silicium, le dioxyde de silicium, le nitrure de silicium, le cuivre et l'aluminium.

12. Le substrat revêtu selon la revendication 11, dans lequel le revêtement est un revêtement de TiO₂.
